# FASCICULE DE BREVET EUROPEEN

(11) **EP 0 666 652 B1**
(45) Date de publication et mention de la délivrance du brevet: **06.05.1999**
(21) Numéro de dépôt: 95400212.7
(22) Date de dépôt: 01.02.1995
(51) Int. Cl.: H03M 7/42, H03M 7/40

(54) **Etage de décalage pour décodeur de codes numériques de longueurs variables**
Verschiebungsstufe für einen Dekodierer von digitalen Kodes veränderlicher Länge
Shifting stage for decoder of digital variable length codes

(30) Priorité: 04.02.1994 FR 9401301
(43) Date de publication de la demande: 09.08.1995
(73) Titulaire: STMicroelectronics S.A., 94253 Gentilly Cédex (FR)
(72) Inventeur: Colavin, Oswald, F-38340 Voreppe (FR)
(74) Mandataire: Michelet, Alain

(56) Documents cités:
- EP-A- 0 493 086
- DE-A- 4 018 133
- US-A- 5 245 338
- PATENT ABSTRACTS OF JAPAN vol. 18 no. 26 (E-1491) ,14 Janvier 1994 & JP-A-05 259922 (OKI ELECTRIC) 8 Octobre 1993,

## Description

L'invention concerne un étage de décalage pour décodeur de codes numériques de longueurs variables.

Un certain nombre de dispositifs de transmission de stockage de données utilise un codage d'informations produisant des codes numériques de longueurs variables. Ces codes sont alors stockés ou transmis les uns à la suite des autres sans séparateur particulier.

Lors du décodage, chaque code est reconnu par une unité logique et l'une des opérations de lecture effectue, sur les données d'entrée, un décalage correspondant au nombre de bits contenus dans le code décodé.

C'est le rôle des étages de décalage pour décodeur de codes numériques de longueurs variables tel que celui de l'invention.

Les techniques de transmission et le stockage d'images numérisées permettent d'améliorer de manière significative la qualité des images finalement obtenues par rapport à la transmission analogique. Il est ainsi possible de multiplier également les applications de ces techniques.

Toutefois, la transmission directe et le stockage d'images numérisées animées nécessite un flux d'informations extrêmement élevé, ce qui rend nécessaire, en pratique, la compression et le codage de ces images.

Ainsi, les images numérisées sont codées avant transmission, de manière à diminuer la quantité d'informations les représentant, puis décodées après transmission.

Les techniques de codage et décodage sont bien entendu essentielles pour la qualité des images finalement obtenues et il est apparu nécessaire, pour assurer la compatibilité des différents matériels mettant en oeuvre ces techniques, d'en assurer une normalisation.

C'est ainsi qu'un groupe d'Experts (Moving Picture Expert Group - MPEG) a mis au point la norme ISO 11172.

Cette norme souvent désignée par le sigle MPEG définit des conditions de codage et de décodage d'images animées, éventuellement associées à un signal sonore, pouvant être utilisées aussi bien pour la mise en mémoire et la restitution d'images que pour leur transmission.

Cette norme MPEG peut donc être utilisée pour le stockage d'images sur des compact discs, compact discs interactifs, sur des bandes magnétiques, être utilisée pour la transmission d'images au travers de réseaux locaux, de lignes téléphoniques comme pour la transmission d'images télévision par voie hertzienne.

La norme définissant de manière complète et détaillée l'ensemble de cette technique est accessible auprès des organismes de normalisation et il convient de s'y référer pour accéder à sa description détaillée.

La compression de données mise en oeuvre selon la norme MPEG peut suivre plusieurs traitements.

Les images consécutives sont tout d'abord collectées, de manière à former un groupe d'images formant une séquence. Une séquence est donc subdivisée en groupes d'images.

Chaque image est divisée en tranches, chaque tranche étant elle-même décomposée en macro-blocs qui constituent l'élément de base utilisé pour appliquer une compensation de mouvements et pour changer, éventuellement, l'échelle de quantification.

Les macro-blocs sont formés d'une matrice 16 x 16 d'éléments d'image (pixels).

Chaque macro-bloc est divisé en six blocs, les quatre premiers portant une information de luminance et les deux autres portant une information de chrominance, respectivement bleue et rouge.

Chacun de ces six blocs est défini comme étant une matrice de 8 x 8 éléments d'images (pixels).

A l'intérieur de chaque séquence, différents types d'images sont définis, de manière à réduire la quantité d'informations à stocker ou à transmettre en raison des analogies existantes entre les informations contenues dans les différentes images d'une même séquence.

Les images I (Intra frames) sont des images codées comme une image immobile et donc sans référence à une autre image.

Les images P (Predicted) sont déduites à partir de l'image I ou P précédemment reconstruite.

Les images B (Bi-directional frames) sont déduites de deux images I et P ou P et P reconstruites, l'une juste avant et l'autre juste après.

Il faut souligner ici que, généralement, l'ordre de transmission des images d'une séquence ne correspond pas à leur ordre de présentation lors de l'acquisition ou de la restitution. Elles sont dans l'ordre de décodage.

La transformation discrète en cosinus (Discrete Cosine Transformation - DCT) est appliquée au niveau des blocs.

Cette transformation DCT transforme des blocs spatiaux, définis comme nous l'avons indiqué plus haut en une matrice 8 x 8 de pixels, en des blocs temporels formés d'une matrice également 8 x 8, de fréquences spatiales.

On a montré que dans la matrice 8 x 8 du bloc temporel, le coefficient de fonds continu (DC) placé en haut à gauche dans la matrice est beaucoup plus important, pour l'impression visuelle obtenue, que les autres composants correspondant à différentes fréquences.

Plus précisément, plus la fréquence est élevée, moins l'oeil y est sensible.

C'est la raison pour laquelle on quantifie les niveaux des fréquences, d'autant plus que les fréquences sont élevées. Cette quantification est assurée par un algorithme qui n'est pas imposé par la norme, qui peut être une opération de quantification et de codage à longueur variable (Variable Length Coding - VLC).

La matrice dans le domaine fréquentiel obtenue par la transformation DCT est ensuite traitée par une matrice dite "matrice de quantification" qui est utilisée pour diviser chacun des termes de la matrice du domaine temporel par une valeur dépendant de sa position et prenant en compte le fait que le poids des différentes fréquences représentées par ces coefficients est variable.

Le résultat de cette opération conduit, après que chacune des valeurs ait été arrondie à la valeur entière la plus proche, à un nombre important de coefficients égal à zéro.

Il faut souligner que, pour les macro-blocs intra, la valeur de quantification du coefficient de fond (DC) est constante, par exemple égale à 8. Les coefficients de fréquence non nuls sont alors codés selon un balayage en zigzag, par référence à une table de Huffman, donnant à chacun des coefficients de la matrice une valeur codée de longueur variable, et réduisant le volume d'information.

De préférence, les coefficients représentant le fonds continu sont transmis après quantification et, par ailleurs, la matrice de quantification est optimisée, de manière à ce que le volume d'informations soit inférieur à un niveau prédéterminé correspondant aux possibilités de stockage ou de transmission, sans que cela porte atteinte de manière excessive à la qualité de l'information transmise.

Les images de type I sont codées sans l'utilisation de vecteur de mouvement.

Au contraire, les images de type P et B utilisent, au moins pour certains des macro-blocs qui les composent, des vecteurs de mouvement permettant d'augmenter l'efficacité du codage et indiquant de quelle partie de la ou des images de référence, un macro-bloc particulier de l'image considérée doit être déduit.

La recherche du vecteur de mouvement fait l'objet d'une optimisation lors du codage et il est lui-même codé en utilisant la technique DPCM qui exploite au mieux la corrélation existante entre les vecteurs de mouvement des différents macro-blocs d'une même image. Ils font finalement l'objet d'un codage à longueur variable (VLC).

Toutes les informations concernant une séquence codée forment le flux d'informations numériques (bitstream) qui est soit enregistré, soit transmis.

Un tel flux d'informations numériques commence par un en-tête de séquence contenant un certain nombre d'informations et de paramètres dont les valeurs sont maintenues pour l'ensemble de la séquence.

De même, la séquence étant décomposée en groupes d'images, chacun de ces groupes est précédé par un entête de groupe et les données représentant chaque image sont elles-mêmes précédées d'un en-tête d'image.

Ainsi, la technique normalisée MPEG de codage d'images animées inclut une telle technique et nécessite donc la mise en oeuvre des étages de décalage, objets de l'invention.

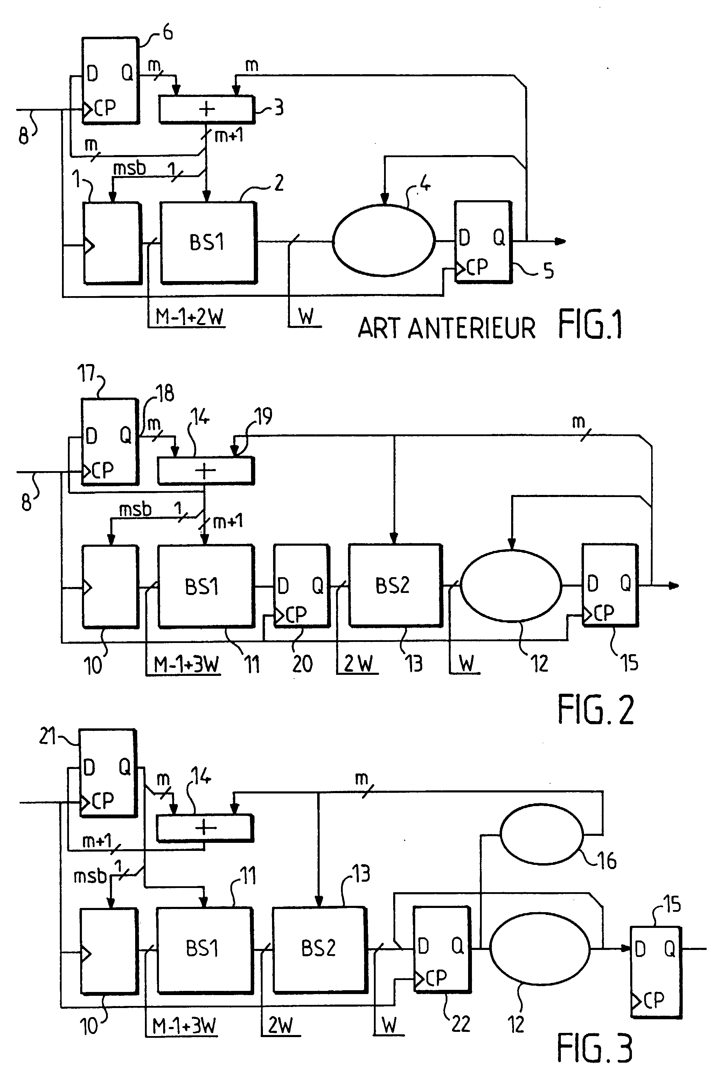

Jusqu'à présent, les étages de décalage pour décodeur de codes numériques de longueurs variables décodant un code par cycle d'horloge sont conformes au dispositif représenté sur la Figure 1.

Un élément de mémorisation 1 acquiert d'une mémoire amont non représentée des données d'entrée composées d'un nombre de bits M.

Le registre à décalage à barillet 2 dont le décalage est commandé par l'additionneur 3, fournit, à l'unité logique 4, un mot ayant une longueur W préalablement définie égale à la longueur maximum d'un code de longueur variable à décoder faisant suite, en raison de la valeur du décalage m+1 défini par l'additionneur 3, aux données numériques présentées par l'élément de mémorisation d'entrée 1 déjà décodées.

L'unité logique 4 décode dans le mot qu'elle a reçu le premier code identifiable et l'adresse à l'unité de mémorisation 5.

Les unités 4 et 5 réalisent une machine à états finis (Finite State Machine) qui peut également être implémentée à l'aide d'un PLA (Programme Logic Array).

L'additionneur 3 coopère avec un élément de mémorisation 6 de telle sorte qu'il reçoit de l'élément de mémorisation 5, la longueur m du code décodé dans le cycle précédent, et de l'élément de mémorisation de cumul 6, la valeur cumulée précédente de l'ensemble des longueurs des codes décodés. Ainsi, il commande le registre à décalage à barillet 2 pour que, tel qu'indiqué plus haut, il effectue un décalage correspondant à la longueur cumulée de l'ensemble des codes déjà décodés par l'unité logique 4 depuis la dernière acquisition, par l'élément de mémorisation d'entrée 1, de données d'entrée.

Lorsque l'accumulateur 3 déborde (msb = 1), il commande une nouvelle opération de lecture par l'élément de mémorisation d'entrée 1.

Le signal d'horloge 8 coordonne l'ensemble de ces opérations.

Ainsi, dans ce dispositif de l'art antérieur, pendant un même cycle d'horloge, doivent être réalisés successivement l'opération d'addition de longueurs des codes préalablement décodés par l'additionneur 3, le décalage par le registre à décalage à barillet 2 des valeurs correspondantes et le traitement logique de décodage par l'unité logique 4.

Le volume total des informations qui doit être traité est imposé par la norme que doit respecter le dispositif dans lequel s'inscrit l'étage de décalage que nous venons de décrire.

La rapidité de ce traitement dépend de la réalisation du circuit et peut être augmentée en multipliant le nombre de portes du circuit réalisé. Cela impose de multiplier la surface des circuits et leur consommation.

Le document US-5.245.338 concerne un décodeur pour longueurs variables qui inclut une partie décodeur et une partie interface. Le décodeur comprend deux éléments de décalage à barillet (barrell shifters) entre lesquels est interposé un registre à verrouillage de décodage (decoder latch).

La demande de brevet EP-A-0.493.086 décrit un décodeur pour images compressées CCITT. Il comprend un traducteur de code suivi d'un séparateur de code et par des décodeurs destinés respectivement à des codes courts et longs.

Le but de la présente invention est la réalisation d'un étage de décalage pour décodeur de codes numériques de longueurs variables rapide en raison de sa structure, sans que cela impose de recourir à un nombre de portes élevé.

C'est un autre objet de l'invention de proposer un étage de décalage pour décodeur de codes numériques de longueurs variables qui soit efficace, fiable et nécessite une surface relativement faible de silicium et une faible consommation électrique.

A cet effet, l'invention concerne un étage de décalage conforme à la revendication 1.

Dans différents modes de réalisation préférés, le dispositif de l'invention comporte les caractéristiques suivantes, prises selon toutes leurs combinaisons techniquement possibles :
- le deuxième registre à décalage à barillet reçoit directement la longueur du code décodé, lors du cycle précédent, adressée par l'unité logique ;
- il comporte un additionneur associé à un élément de mémorisation recevant à chaque cycle la longueur du code décodé, cumulant ces longueurs depuis la dernière lecture des données d'entrée, commandant le décalage du premier registre et la lecture d'une nouvelle donnée d'entrée ;
- il est réalisé sous forme d'un circuit intégré en technique VLSI (Very Large Scale Integrated Technology) ;
- il est destiné au décodage d'un signal vidéo codé selon la norme MPEG par transformation cosinusoïdale discrète (DCT) et quantification ;
- il est destiné au décodage d'informations enregistrées sur un disque compact numérique interactif ;
- il est destiné au décodage d'informations enregistrées sur une bande magnétique ;
- il est destiné au décodage d'informations transmises par voie hertzienne.

Un mode de réalisation de l'invention sera décrit en détail en référence aux dessins annexés, dans lesquels :
- la Figure 1 est un exemple de réalisation de l'art antérieur décrit plus haut ;
- la Figure 2 est une représentation schématique d'un premier mode de réalisation destiné à faciliter la compréhension de l'invention ;
- la Figure 3 est une représentation schématique d'un deuxième mode de réalisation correspondant à l'invention.

Dans les deux modes de réalisation, les données sont acquises de l'extérieur par une unité de mémorisation 10, directement reliée à un premier registre à décalage à barillet 11.

L'unité logique 12 effectue le traitement de décodage et fournit, d'une part, à un deuxième registre à décalage à barillet 13 et, d'autre part, à un additionneur 14, la valeur m de la longueur du dernier code à longueur variable décodé. L'unité logique 12 fournit, à un élément de mémorisation 15, le résultat de son traitement.

L'additionneur 14 commande lorsqu'il déborde (msb = 1), une nouvelle opération de lecture par l'unité de mémorisation d'entrée 10.

Nous décrirons maintenant le premier mode de réalisation, plus particulièrement en référence avec la Figure 2.

Une unité de mémorisation de cumul 17 est reliée à la sortie de l'additionneur 14 dont elle alimente, par sa sortie 18, l'une des entrées, alors que l'autre 19, comme indiqué plus haut, est alimentée à partir de l'unité de mémorisation 15 par une valeur m représentant la longueur du code décodé lors du cycle d'horloge précédent.

Une unité de mémorisation 20 est interposée entre le premier registre à décalage à barillet 11 et le deuxième registre à décalage à barillet 13.

Ainsi, selon ce dispositif, à un temps d'horloge donné, le premier registre à décalage à barillet 11 reçoit un signal de commande de décalage m+1 correspondant à la somme des longueurs des codes décodés depuis la dernière instruction de lecture reçue par l'unité de mémorisation d'entrée 10 jusqu'à l'instant précité. L'unité de mémorisation 1, interposée entre le premier registre à décalage à barillet 11 et le deuxième registre à décalage à barillet 12, contient, pendant ce temps, la valeur précédente fournie par le premier registre à décalage à barillet 11 correspondant au décalage produit par les valeurs cumulées de longueurs de codes décodés depuis l'instant de lecture par l'unité de mémorisation d'entrée 10 jusqu'au temps t-1. Une valeur produite par l'unité de mémorisation 20 est reçue en entrée par le registre à décalage à barillet 13 qui, recevant une commande de décalage m correspondant à la longueur du code décodé pendant le temps d'horloge précédent par l'unité logique 12, fournit à sa sortie pour l'alimentation de l'unité logique 12 des données décalées du cumul du décalage produit au cycle précédent par le registre à décalage à barillet 11 et de sa propre valeur de décalage, c'est-à-dire de la longueur cumulée des codes décodés depuis l'instruction de lecture jusqu'à et y compris le cycle précédent par l'unité logique 12.

Ainsi, l'unité logique 12 accède, parmi les données mémorisées par l'unité de mémorisation 10, aux données recherchées, c'est-à-dire à celles suivant exactement les codes déjà décodés.

Il est important de souligner que dans ce dispositif, la limitation du temps de traitement est produite uniquement par l'action conjointe du registre à décalage à barillet 13 et de l'unité logique 12.

En effet, pendant ce temps d'horloge, il est nécessaire que le deuxième registre à décalage à barillet 13 reçoive la valeur de décalage m produite à partir du résultat fourni par l'unité logique 12, réalise ce décalage, puis que l'unité logique ayant accès à une donnée d'entrée convenablement définie, effectue son traitement.

Pendant ce temps également, le premier registre à décalage à barillet 11 travaillant sur des informations résultant non du cycle précédent t-1, mais des informations provenant du cycle t-2, peut effectuer ses propres opérations.

La valeur du décalage produite par les registres à décalage étant un facteur limitatif du temps nécessaire pour ces opérations, on a ainsi obtenu un gain important puisque le deuxième registre à décalage à barillet 13 ne peut avoir à réaliser un décalage qu'au plus égal à la longueur du code maximum susceptible de se présenter. Dans la réalité, cette longueur est souvent bien inférieure au décalage global. Seule cette durée de traitement par le deuxième registre à décalage à barillet 13 est cumulée avec la durée de traitement par l'unité logique 12.

Au contraire, le registre à décalage à barillet 11 qui doit être à même de pouvoir produire des décalages beaucoup plus importants, est autonome et peut utiliser l'intégralité de la durée d'un temps d'horloge pour réaliser ses propres opérations.

Nous décrirons maintenant le deuxième mode de réalisation, en référence à la Figure 3, dans lequel les éléments communs, remplissant la même fonction que ceux du premier mode de réalisation, ont été référencés avec la même numérotation.

L'unité de mémorisation 21 reçoit en entrée le signal produit par l'additionneur 14, alimente par sa sortie d'une part, comme dans le premier mode de réalisation, l'additionneur 14, mais aussi le premier registre à décalage à barillet 11.

Le deuxième registre à décalage à barillet 13 est directement relié au premier registre à décalage à barillet 11. Egalement comme dans le premier mode de réalisation, il reçoit comme commande de décalage la valeur m de la longueur du dernier code décodé.

Ainsi, le deuxième registre à décalage à barillet 13 fournit à une unité de mémorisation 22, placée entre le registre à décalage à barillet 13 et l'unité logique 12, une donnée extraite des données d'entrée reçues par l'unité de mémorisation d'entrée 10 décalée, une longueur égale au cumul des longueurs des codes décodés jusque et y compris le temps d'horloge précédent.

L'unité logique 12 acquiert ces données de l'unité de mémorisation 22 et peut ainsi réaliser son traitement.

Parallèlement, une logique de longueur 16 est à même de fournir la longueur du code décodé sur le cycle précédent, le deuxième registre à décalage à barillet 13 reçoit cette valeur et l'applique à la donnée disponible issue du premier registre à décalage à barillet 11 et fournit ainsi, de manière stable, par l'unité de mémorisation 22, la valeur d'entrée nécessaire à l'unité logique 12 pour réaliser le cycle suivant.

Pendant ce temps, l'additionneur 14 recevant la valeur de la longueur du dernier code décodé alimente l'unité de mémorisation 21 qui modifie la valeur de décalage du registre à décalage à barillet 11. Celui-ci effectue son traitement et, par un nouveau décalage, se met en disponibilité pour le cycle suivant.

Ici encore, la durée limitant la vitesse de fonctionnement de cet étage de décalage résulte du cumul de la durée de décalage nécessaire au deuxième registre, limitée comme dans l'exemple précédent encore à la longueur maximum d'un code à détecter, calculée avec le temps de traitement de l'unité logique 12.

De son côté, le registre à décalage à barillet 11 qui peut être amené à réaliser un décalage beaucoup plus important puisqu'il s'agit du décalage de la longueur cumulée des codes détectés depuis la dernière instruction de lecture, dispose de l'intégralité du temps d'horloge pour réaliser son opération.

On comprend donc que dans l'un et l'autre des modes de réalisation, l'utilisation de deux registres à décalage permet de décomposer l'opération de décalage en deux sous-opérations qui sont réalisées simultanément l'une et l'autre. Il s'agit, d'une part, du décalage principal réalisé par le premier registre pour une valeur égale au cumul de la longueur des codes détectés jusqu'au temps d'horloge t-1 et, d'autre part, d'un décalage plus faible correspondant à la seule valeur de la longueur du code décodé au temps t-1 et avec l'opération logique.

Cette décomposition permet la réalisation des circuits correspondants avec une surface de silicium minimum et, par là, un coût de fabrication et une consommation lors de l'utilisation également minimum.

## Revendications

1. Etage de décalage pour décodeur de codes numériques de longueurs variables décodant un code par cycle d'horloge comprenant des moyens pour
lire des données d'entrée en provenance d'une mémoire,
fournir à une unité logique de décodage, à chaque cycle, un mot ayant la longueur maximum d'un code de longueur variable à décoder,
recevoir l'unité logique le nombre de bits du code décodé au cycle d'horloge précédent,
et effectuer un décalage, dans les données lues, égal au cumul des longueurs des codes préalablement décodés depuis la dernière lecture des données d'entrée,
l'étage de décalage comportant un premier registre à décalage à barillet (11) pour lire les données d'entrée et effectuer un décalage dans les données lues égal au cumul des longueurs des codes décodés entre le cycle précédent et le début de la dernière lecture, et un deuxième registre à décalage à barillet (13) pour recevoir les données provenant du premier registre et effectuer un décalage égal à la longueur du code décodé lors du cycle précédent,
caractérisé en ce que les données fournies par le premier registre à décalage à barillet (11) alimentent directement le deuxième registre à décalage 13), et qu'un élément de mémorisation (22) est interposé entre le deuxième registre à décalage à barillet (13) et l'unité logique (12).

2. Etage de décalage selon la revendication 1, caractérisé en ce que le deuxième registre à décalage à barillet (13) reçoit directement la longueur du code décodé, lors du cycle précédent, adressée par l'unité logique (12).

3. Etage de décalage selon l'une des revendications 1 ou 2, caractérisé en ce qu'il comporte un additionneur (14) associé à un élément de mémorisation recevant à chaque cycle la longueur du code décodé cumulant ces longueurs depuis la dernière lecture des données d'entrée, commandant le décalage du premier registre et la lecture d'une nouvelle donnée d'entrée.

4. Etage de décalage selon l'une quelconque des revendications 1 à 3, caractérisé en ce qu'il est réalisé sous forme d'un circuit intégré en technique VLSI.

5. Etage de décalage selon l'une quelconque des revendications 1 à 4, caractérisé en ce qu'il est destiné au décodage d'un signal vidéo codé selon la norme MPEG par transformation cosinusoïdale discrète (DCT) et quantification.

6. Etage de décalage selon l'une quelconque des revendications 1 à 5, caractérisé en ce qu'il est destiné au décodage d'informations enregistrées sur un disque compact numérique interactif.

7. Etage de décalage selon l'une quelconque des revendications 1 à 5, caractérisé en ce qu'il est destiné au décodage d'informations enregistrées sur une bande magnétique.

8. Etage de décalage selon l'une quelconque des revendications 1 à 5, caractérisé en ce qu'il est destiné au décodage d'informations transmises par voie hertzienne.

## Patentansprüche

1. Schiebestufe für einen Dekodierer von digitalen Kodes variabler Länge, welcher einen Kode pro Taktzyklus dekodiert, mit Einrichtungen zum
- Lesen von aus einem Speicher kommenden Eingangsdaten,
- Liefern eines Wortes in jedem Zyklus an eine logische Dekodiereinhelt, wobei das Wort die maximale Länge eines zu dekodierenden Kodes mit variabler Länge hat,
- Empfangen der Bitzahl des während des vorhergehenden Taktzyklus empfangenen Kodes von der logischen Einheit,
- und Durchführen einer Verschiebung in den gelesenen Daten, die dem kumulierten Wert der Länge der seit dem letzten Lesen der Eingangsdaten dekodierten Kodes entspricht,
- wobei die Schiebestufe aufweist: ein erstes Trommel-Schieberegistet (11) zum Lesen der Eingangsdaten und zum Durchführen einer Verschiebung in den gelesenen Daten, die dem kumulativen Wert der Länge der zwischen dem vorherigen Zyklus und dem Beginn des letzten Lesevorgangs dekodierten Kodes entspricht, und ein zweites Trommel-Schieberegister (13) zum Empfangen der vom ersten Register kommenden Daten und zum Durchführen einer Verschiebung entsprechend der Länge des während des vorhergehenden Zyklus dekodierten Kodes,
dadurch gekennzeichnet, daß die vom ersten Trommel-Schieberegister (11) gelieferten Daten direkt dem zweiten Schieberegister (13) zugeführt werden und daß zwischen dem zweiten Trommel-Schieberegister (13) und der logischen Einheit (12) ein Speicherelement (22) angeordnet ist.

2. Schiebestufe nach Anspruch 1, dadurch gekennzeichnet, daß das zweite Trommel-Schieberegister (13) die Länge des während des vorhergehenden Zyklus dekodierten Kodes direkt von der logischen Einheit (12) empfängt.

3. Schiebestufe nach einem der Ansprüche 1 oder 2, dadurch gekennzeichnet, daß sie einen Addierer (14) aufweist, der einem Speicherelement zugeordnet ist, und der zu jedem Zyklus die Länge des dekodierten Kodes empfängt, diese Längen seit dem letzten Lesevorgang der Eingangsdaten kumuliert, die Verschiebung des ersten Registers und das Lesen neuer Eingangsdaten steuert.

4. Schiebestufe nach einem der Ansprüche 1 bis 3, dadurch gekennzeichnet, daß sie als integrierte VLSI-Schaltung ausgebildet ist.

5. Schiebestufe nach einem der Ansprüche 1 bis 4, dadurch gekennzeichnet, daß sie zum Dekodieren eines durch diskrete Kosinus-Transformation (DCT) und Quantifizierung nach der MPEG-Norm kodierten Videosignals dient.

6. Schiebestufe nach einem der Ansprüche 1 bis 5, dadurch gekennzeichnet, daß sie dem Dekodieren von Informationen dient, die auf einer interaktiven digitalen CD gespeichert sind.

7. Schiebestufe nach einem der Ansprüche 1 bis 5, dadurch gekennzeichnet, daß sie dem Dekodieren von auf einem Magnetband gespeicherten Informationen dient.

8. Schiebestufe nach einem der Ansprüche 1 bis 5, dadurch gekennzeichnet, daß sie dem Dekodieren von über Funk übertragenen Informationen dient.

## Claims

1. Shifter stage for variable-length digital codes decoder decoding one code per clock cycle comprising means for
reading input data originating from a memory,
supplying a decoding logical unit on each cycle with a word having the size of the longest variable-length code to be decoded,
receiving from the logical unit the number of bits of the code decoded on the preceding clock cycle,
and performing a shift in the read data equal to the cumulative total of the lengths of codes already decoded since the last read of the input data,
the shifter stage comprising a first barrel shift register (11) for reading the input data and performing a shift in the data read equal to the cumulative total of the lengths of codes decoded between the preceding cycle and the start of the last read,
and a second barrel shift register (13) for receiving data arriving from the first register and performing a shift equal to the length of the code decoded at the time of the preceding cycle,
characterized in that the data supplied by the first barrel shift register (11) directly supply the second shift register (13), a memory block (22) being interposed between the second barrel shift register (13) and the logical unit (12).

2. The shifter stage of claim 1, characterized in that the second barrel shift register (13) directly receives the length of the code decoded on the preceding cycle from the logical unit (12).

3. The shifter stage of any one of claims 1 or 2 characterized in that it comprises an adder (14) associated with a memory block which receives on each cycle the length of the code decoded, calculates the cumulative total of these lengths since the last read of input data, commands the shift of the first register and the reading of a new input data.

4. The shifter stage of any one of claims 1 to 3, characterized in that it is produced in the form of an integrated circuit by VLSI technology.

5. The shifter stage of any one of claims 1 to 4, characterized in that it is intended for decoding a video signal coded according to the MPEG standard by Discrete Cosine Transformation (DCT) and quantization.

6. The shifter stage of any one of claims 1 to 5, characterized in that it is intended for decoding data recorded on an interactive digital compact disc.

7. The shifter stage of any one of claims 1 to 5, characterized in that it is intended for decoding data recorded on a magnetic tape.

8. The shifter stage of any one of claims 1 to 5, characterized in that it is intended for decoding data transmitted by radio waves.
